# EUROPEAN PATENT SPECIFICATION

(11) **EP 2 593 586 B1**
(45) Date of publication and mention of the grant of the patent: **06.09.2017**
(21) Application number: 11748300.8
(22) Date of filing: 13.07.2011
(51) Int. Cl.: C25D 1/00, C25D 7/12, C25D 17/06, C25D 17/00, C25D 17/14, H01L 21/687, H01L 21/67, H01L 21/683

(54) **A CHUCK, AND A METHOD FOR BRINGING A FIRST AND A SECOND SUBSTRATE TOGETHER**
FUTTER UND VERFAHREN ZUM ZUSAMMENBRINGEN EINES ERSTEN UND EINES ZWEITEN SUBSTRATS
SUPPORT DE SUBSTRAT, ET PROCÉDÉ DE RÉUNIR UN PREMIER ET UN SECOND SUBSTRAT

(30) Priority: 16.07.2010 US 364989 P; 15.07.2010 SE 1050796
(43) Date of publication of application: 22.05.2013
(60) Divisional application: 17184006.9
(73) Proprietor: Luxembourg Institute of Science and Technology (LIST), 4362 Esch-sur-Alzette (LU)
(72) Inventor: MÖLLER, Patrik, S-112 32 Stockholm (SE); FREDENBERG, Mikael, S-112 45 Stockholm (SE); LINDGREN, Lennart, S-125 33 Älvsjö (SE); SANTOS, Antonio, S-164 45 Kista (SE); CHAUVET, Jean-Michel, S-125 43 Älvsjö (SE); UTTERBÄCK, Tomas, S-762 61 Rimbo (SE); ROSÉN, Daniel, S-112 44 Stockholm (SE); WIWEN-NILSSON, Peter, S-114 50 Stockholm (SE)
(74) Representative: Lecomte & Partners
(86) International application number: PCT/EP2011/061990
(87) International publication number: WO 2012/007520

(56) References cited:
- WO-A1-02/103085
- US-A1- 2007 131 563
- US-A1- 2010 097 738

## Description

### Field of the Invention

This invention pertains in general to the field of electrochemical pattern replication. More particularly the invention relates to a chuck, and a method for bringing a master electrode in contact with a substrate.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can also be used for different types of structures in conductive polymers, structures in semiconductors, structures in metals, and others. Even 3D-structures in silicon, such as by formation of porous silicon, are possible.

Chemical vapour deposition and physical vapour deposition are processes that may also be used for metallization, but electroplating/electroetching is often preferred since it is generally cheaper than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface on the master electrode, an insulating material, defining the pattern to be plated/etched, and the conductive surface of the substrate. During plating, a predeposited anode material has been arranged, normally through electrochemical plating, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

When bringing the master electrode and the substrate together it is important to ensure filled plating/etching cavities, to guarantee uniform plating/etching in the cavities. Otherwise, the plating height or etching depth may be heterogeneous over the substrate, leading to a poor product. Further, it is of high importance to provide contact between the insulating material defining the walls of the cavities and the substrate, in order to prevent electrolyte trapped inside the cavities to escape and allow plating or etching outside the boundaries of the cavities.

US 2007/0131563 A discloses an electrochemical process for electroplating and a chuck suitable for holding a master electrode or a substrate, in accordance with the preamble of claim 1.

US 2002/062921 describe a chuck configured to hold a substrate. The chuck of this system clamps a wafer at its periphery while introducing a high pressure at the centre of the chuck. In US 2002/062921 the wafer is clamped at its circumference, while a pressure behind the wafer will make the wafer bow while loosing contact with the chuck.

This solution has a number of drawbacks. For example, the applied pressure must be controlled in a very strict manner to avoid that the clamping at the periphery or at the centre of the wafer is released. Also, electrical contact between the wafer and the chuck is limited to the periphery, leading to unsatisfactory deposition characteristics. Moreover, since semiconductor wafers are very brittle along its crystal plane a too high pressure may easily crack the wafer. These disadvantages disqualify those chucks for use with ECPR.

Hence, an improved system would be advantageous, and in particular a method and a device allowing for improved assurance of filled plating/etching cells would be advantageous as well as chucks adapted for obtaining such assurance.

### Summary of the Invention

Accordingly, the present invention preferably seeks to mitigate, alleviate or eliminate one or more of the above-identified deficiencies in the art and disadvantages singly or in any combination and solves at least the above mentioned problems by providing a device according to the appended patent claims.

### Brief Description of the Drawings

These and other aspects, features and advantages of which the invention is capable of will be apparent and elucidated from the following description of embodiments of the present invention, reference being made to the accompanying drawings, in which
Fig. 1 a is a side view of an ECPR system;
Fig. 1b is a schematic view of a concept not belonging to the invention;
Fig. 2a is a side view of a device having a chuck for holding an ECPR master electrode and/or a substrate, which does not belong to the invention;
Fig. 2b is a side view of a device having a chuck for holding an ECPR master electrode and/or a substrate, which does not belong to the invention;
Fig. 3 is a side view of a device having a chuck for holding an ECPR master electrode and/or a substrate according to the invention.
Fig. 4 is a side view of a device having a chuck for holding an ECPR master electrode and/or a substrate, which does not belong to the invention.
Fig. 5 is a side view of a device having a chuck for holding an ECPR master electrode and/or a substrate, which does not belong to the invention;

### Description of embodiments

The following description focuses on an embodiment of the present invention applicable to a chuck for holding an ECPR master electrode and/or a substrate and in particular to a device and a method for continuously increasing the contact area between the front sides of the master electrode and the substrate in an analog way towards the borders thereof. However, it will be appreciated that the invention is not limited to this application but may be applied to many other replicating or etching processes within the field of micro electronics and/or mechanics, including for example wafer bonding, various lithographic processes, dry or wet etching processes, etc.

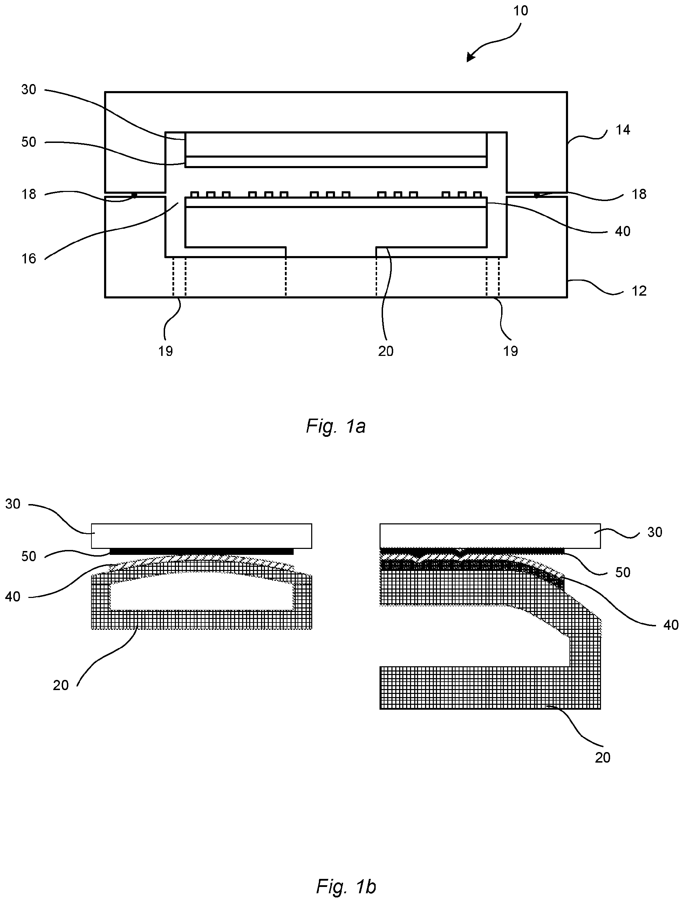

In Fig. 1a, a system for ECPR is schematically shown. During ECPR the master electrode 40 and the substrate 50 are arranged in an ECPR chamber 10 on a lower and upper chuck 20, 30, respectively, which are brought together by the operation of a suitable mechanics and/or software. The ECPR chamber 10 is the chamber wherein ECPR is intended to take place. The chamber is limited by a lower and an upper chamber piece 12, 14, which create the compartment 16 when brought together. Between the upper and lower chamber pieces 12, 14 a seal 18 may be arranged, such that electrolyte can be prohibited from leaving the ECPR chamber and thus damaging electrical components outside the ECPR chamber. The seal 18 is preferably a ring shaped seal, such as an O-ring, located at an interconnection area between the lower and upper piece 12, 14, thus enclosing the ECPR chamber 10. The chamber 10 is provided with necessary electric leads to the conductive layer of the master electrode 40 and the seed layer on the substrate 50. The chamber 10 is also provided with conduits 19 for guiding electrolyte to and from the chamber 10. Preferably, the conduits 19 are connected to the ECPR chamber 10 below the surface of the lower chuck 20. The inlet conduit 19 may thus be arranged such that the inlet is located in the bottom of the ECPR chamber 10. In this way, the chamber 10 is filled with electrolyte from below. This ensures a minimal presence of gas bubbles in the cavities of the master electrode 40 once the electrolyte surmounts the master electrode 40 arranged on the lower chuck 30.

The lower chuck 20 is adapted to minimize the thickness and variations in residual film of electrolyte, without local and/or global entrapment of electrolyte. This is ensured by bringing the master electrode 40 and the substrate 50 together in a manner such that the surface of a front side of the master electrode 40, carrying the patterned insulating layer forming a pattern of conductive cavities there between, and the surface of a front side of the substrate 50, being the side of the substrate intended for pattern replication or etching, into contact by continuously increasing the contact area between the front sides towards the borders thereof. This may be accomplished by adapting the lower chuck 20 such that the master electrode 40, and thereby the front side of the master electrode is slightly bent into a convex form. Alternatively, the lower chuck may be adapted for arranging the front side master electrode 40, such that the plane of extension thereof is slightly angled with respect to the plane of extension of the front side of the substrate 50.

In Fig. 1b a schematic view of a concept. Here it is disclosed how the master electrode 40 is bent by a convex shape of the lower chuck 20, and how, during movement of the upper chuck 20 and the lower chuck 30 towards each other, while the master electrode is in a bent/convex shape, pushes electrolyte towards the periphery of the master electrode 40 and the substrate 50, while increasing the contact area between the two. Thus, the macro scale convex shape minimizes the risk of entrapment of electrolyte in between the master and the substrate. When a conformable/flexible sheet is positioned in between the master and lower chuck, also unevenness on the master and/or substrate side, such as particles on the backside or protruding unevenness on the front side of the master and/or substrate, may be compensated for, to also minimize the risk of electrolyte entrapment on the local scale.

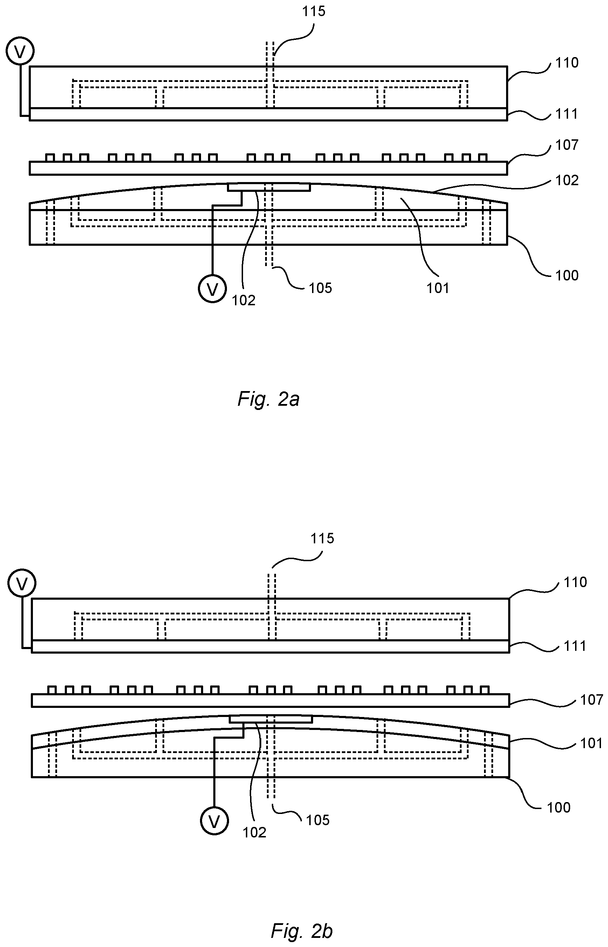

With reference to Fig. 2a, a device having a chuck 100 is shown. The ECPR equipment includes a process chamber with two chucks 100, 110 onto which the master electrode 107 and the substrate 111, respectively, are attached.

The upper chuck 110 holding the substrate 111 has a planar polished surface in this example, for arrangement of the substrate thereon. The lower chuck 100 holding the master electrode 107 comprises a planar polished intermediate surface of a under the circumstances substantially non-flexible material, such as stainless steel of thick dimensions, onto which a under the circumstances flexible disc 101 is applied. The flexible disc 101 comprises an adhesive flexible sheet, to be applied on the planar intermediate surface of the lower chuck 100. Further, the flexible disc may comprise a thin conductive sheet/foil thereon, having a conductive surface facing distally towards the master electrode 107, and creating electrical contact with the underside of the master electrode 107. However, it is equally possible to apply a separate conductive foil distally of the flexible sheet. When the conductive foil is a separate foil, detachable from the flexible sheet, the conductive foil may be separately exchanged due to wear. The conductive sheet/foil may have terminals extending radially outwards and contactable circumferencially of the master electrode 107. A suitable material for the adhesive flexible sheet is a rubber material or a polymeric material, such as elastomers, being compressible/deformable during the relevant circumstances. A suitable material for the conductive sheet is copper, which may be combined with other materials such as nickel, gold, silver, platinum, palladium or alloys thereof. The adhesive flexible sheet may be perforated with a plurality of perforations, to make the flexible sheet not so movable in the lateral direction, when being compressed. The perforations then act as a compensation for volume reduction, allowing for vertical compression while minimizing movement in lateral direction, whereby alignment of substrate and master electrode is improved.

Instead of a conductive foil conductive leads may be arranged through vias arranged in the adhesive flexible sheet or conductive leads circumferentially of the master electrode. When the conductive foil is used, an even current distribution may be provided.

The flexible disc 101 comprises a planar proximal surface, facing and attached to the planar polished intermediate surface, and a dome shaped or convex distal or upper surface. The dome shaped or convex distal or upper surface is the result of the lower chuck 100 having a convex Euclidean space in the macro scale in between the distal or upper surface and a plane perpendicular to the central axis, i.e. the proximodistal axis, of the lower chuck 100, said distal or upper surface intersecting said plane in a closed line. The cross-section of the distal or upper surface along the transversal plane may then be substantially segmental arch shaped, triangular arch shaped, lancet arch shaped, round arch shaped, or any of these with a flattened distal top. When the Euclidean space is substantially a spherical segment, i.e. when the cross-section of the distal or upper surface along the transversal plane may then be substantially segmental arch shaped, and the surface of the spherical segment substantially corresponds to the distal or upper surface, a reliable interaction with the master electrode or substrate may be obtained, with the allowance of good electrical contact on the backside of said master electrode or said substrate, without risking undue mechanical stress on said master electrode or substrate. The dome shaped or convex distal or upper surface is intended for interaction with the master electrode in use. The flexible disc 101 thus comprises an interaction surface 102 between the master electrode and the chuck 100. When the flexible disc 101 comprises a planar proximal surface towards the planar polished surface and a dome shaped or convex distal or upper surface, intended for interaction with the master electrode in use, the chuck 100 may be used for master electrodes of different diameters, since the allowable flexing depth spans over a large interval.

The interaction surface 102 of the chuck 100 is provided with an electrically conductive member 103, such as the electrically conductive sheet/foil according to above. The conductive member 103 is in conductive communication with electrical leads allowing for connecting the conductive member 103 with an external power supply, whereby the conductive member 103 may be current-carrying. The electrical leads may be provided through the flexible disc 101 or it may be provided at the circumference of the thin conductive film on the flexible sheet. The conductive member 103 may be arranged on the interaction surface 102 such that the conductive member 103 conductively connects to conductive parts on the master electrode 107 to be arranged on the chuck 100, said conductive parts of the master electrode 107 being in conductive communication with the conductive surface in cavities of the master electrode. The electrically conductive member 103 and the electrical leads may then be spread over the interaction surface 102, whereby electrical contact with the master electrode may be more homogenous than a limited electrical contact at the periphery of the master electrode. Thus, a better controlled ECPR process may be obtained.

The lower chuck 100 and the upper chuck 110 are facing each other and they both have small vacuum channels 105, 115. These vacuum channels act as attachment means to provide a reliable fixation of the master electrode 107 and the substrate 111. To prevent local deformation of the master electrode 107 and the substrate 111 according to the pattern obtained by the mouths of vacuum channels 105, 115, due to the lower pressure provided therein, the width of the vacuum grooves is kept small, e.g. less than 1 mm in diameter. For the same reason the vacuum channels may have a width that is kept small, such as less than 1 mm. The vacuum channels 105 of the lower chuck 100 extend through the flexible disc 101, such that the master electrode 107 conforms to the convex shape when vacuum is applied to the grooves 105. The mouths of the vacuum channels may be evenly distributed on the side of the lower chuck 100 facing the master electrode 107, such that an even vacuum force is obtained on the backside of the master electrode 107. In this way detainment of the master electrode 107 to the lower chuck 100 and conformation between the master electrode 107 and the lower chuck 100 may be increased while simultaneously keeping demands on the vacuum creating unit low.

When the backside of the master electrode 107 concavely conforms to the convex shape of the lower chuck 100, the front side of the master electrode 107 will natively conform into a convex shape corresponding to the convex shape of the lower chuck 100.

After the master electrode 107 has been fixated onto the lower chuck by means of the applied vacuum, and after loading the substrate 111 on the upper chuck 110, the process chamber is filled up with electrolyte. Alternatively, a thin film of electrolyte is dispensed only onto the surface of the master electrode 107. Subsequently, the chucks 100, 110 are brought into contact while keeping the chucks 100, 110 in parallel. Alternatively, the substrate 111 is loaded on the upper chuck 110 after a thin film of electrolyte is dispensed on the surface of the master electrode 107.

When brought into contact the master electrode 107 is pressed in an up-wise direction towards the substrate 111 by means of an external pressure source (not shown). Alternatively, the substrate 111 is pressed in a down-wise direction towards the master electrode 107 by means of an external pressure source (not shown). Hence, a first contact is established between the centre of the master electrode 107 and the centre of the substrate 111. As the pressure continues, the flexible disc 101 will be deformed towards a planar shape, and consequently the master electrode 107 will also return to its planar shape. During this process, all excessive electrolyte will be forced to move away from the centre towards the periphery of the master electrode/substrate sandwich. Hence, mechanical contact will be established between the patterned surface of the master electrode 107 and the substrate 111.

The pressure may preferably be applied during the entire process cycle, giving rise to a continuous transport of small volumes of excessive electrolyte towards the circumference and ensure that excessive electrolyte, already transported away from the interface between the master electrode and substrate surfaces, is kept away from the interface during the entire process cycle.

When the ECPR process is finished, a separation force may be applied to move the chuck 100 away from the chuck 110 holding the substrate 111 in a controlled way, preferably while keeping the two surfaces of the chucks 100, 110 completely in parallel during the entire separation process.

As an alternative an external separation stage can be used in order to be able to keep the two chucks 100, 110 in parallel during separation.

After separation cleaning with different chemicals may be performed before unloading the substrate 111 or master electrode 107 from the equipment and initiating next ECPR cycle.

A further example is shown in Fig. 2b. Here, the lower chuck 100 comprises a dome shaped or convex intermediate surface and a substantially planar flexible disc 101, with a substantially even thickness, arranged on top of or distally of the dome shaped or convex surface, such that the flexible disc 101 concavely conforms to the dome shaped or convex surface on the side of the flexible disc 101 facing the dome shaped or convex surface.

Simultaneously, the upper surface of the flexible disc 101 will be natively convex in shape, corresponding to the convexity of the dome shaped or convex surface. The flexible disc 101 may be permanently attached to the dome shaped or convex surface, or it may conform to the convex shape of the dome shaped or convex surface only upon applied vacuum. When the flexible disc 101 has a substantially even thickness, the amount of flexible material may be reduced.

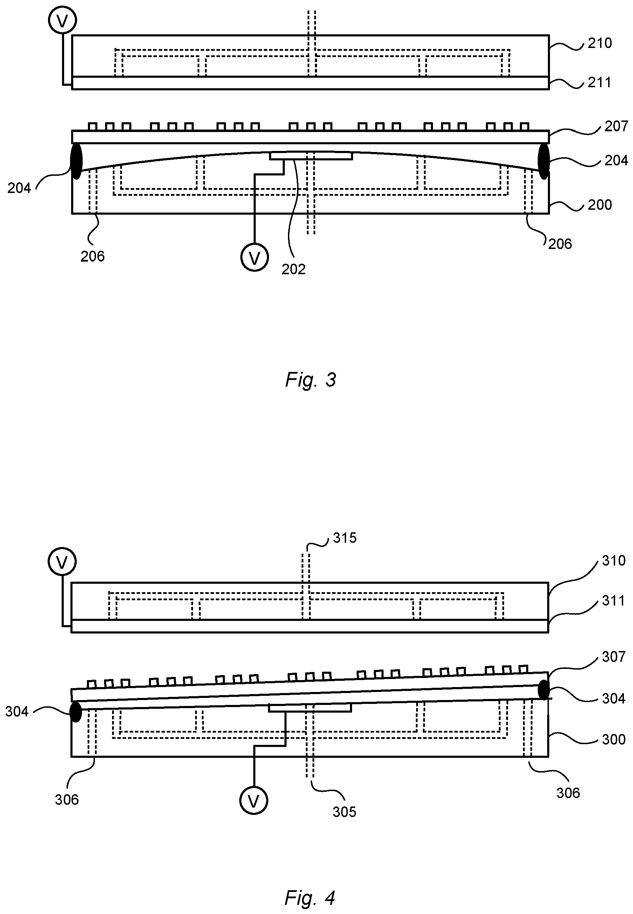

An embodiment of the invention is schematically shown in Fig. 3, where a chuck 200 is provided. A master electrode 207 is arranged on top of the chuck 200 during the ECPR process. The chuck 200 is thus a chuck for holding an ECPR master electrode 207 during an ECPR in an ECPR chamber, such that a front side of the master electrode 207, carrying the patterned insulating layer forming a pattern of conductive cavities there between, is facing outwards from the chuck 200 and towards a substrate 211 to be patterned during an ECPR process.

The backside of the master electrode 207 is facing an interaction surface 201 on the chuck 200. The interaction surface 201 of the chuck 200 is provided with an electrically conductive member 202, for providing a voltage and current to the master electrode 207. The conductive member 202 may also be a foil, in accordance with above. It is also possible to provide circumferential conductive members.

Further, the interaction surface 201 is slightly convex in three dimensions, i.e. slightly dome shaped. For example, the interaction surface 201 has the form of a spherical cap. The radius for the base of spherical cap may correspond to the radius of the substrate to be patterned, i.e. in case of 8 inch (or 200 mm) wafers the radius is 4 inch (or 100 mm) and in case of 12 inch (or 300 mm) wafers, the radius is 6 inch (or 150 mm). In another example, the interaction surface may be conically shaped, or of any other shape leading to a continuously increasing topography of the interaction surface 201 when going from the circumference towards the centre. The interaction surface 201 may be made of a flexible disc according to what has previously described, or it may be formed integrally with the chuck 200. In the latter case, the interaction surface 201 is thus made of a rigid material, i.e. a material that does not deform during the ECPR process.

The chuck 200 further comprises a seal 204, intended for sealing off the substantial part of the backside of the master electrode 207 from electrolyte. Since the backside, or at least parts thereof, of the master electrode 207 is current-carrying or charged during operation of the ECPR chamber, contact between the backside and the electrolyte during operation would lead to plating of material being present in the electrolyte as ions or etching of possibly soluble parts of the master electrode 207 depending on if the master electrode is anode or cathode during said operation. The seal 204 may thus preferably be a ring-shaped seal, such as an O-ring, being adapted in its extension to the shape of the master electrode 207.

The seal 204 is inflatable or by other means adjustable in a direction perpendicular to the surface of the master electrode 207. Since the master electrode 207 most of the time is adapted in size and shape in respect of the substrate 211 to be plated/etched, and the standard shape of such substrates 211 are circular with a diameter between 100 to 500 mm, such as between 200 to 300 mm, the seal 204 may be arranged on the chuck 200 as a circle having a diameter of approximately 100 to 500 mm, such as approximately between 200 to 300 mm. The seal 204 is preferably of an elastomeric material. Suitable materials are selected from the group comprising synthetic rubbers and thermoplastics.

The chuck 200 further comprises an attachment means 205 for controllably attaching the master electrode 207 to the chuck 200 during ECPR. The attachment means 205 may be at least one low pressure suction nozzle creating a lower pressure in the compartment defined by the chuck 200, the seal 204 and the backside of the master electrode, than in the ECPR chamber. Thus, the master electrode 207 is held into place on the interaction surface 201 of the chuck 200. The attachment means 205 includes small vacuum channels arranged on the upper surface of the chuck 200 in order to provide a reliable fixation of the master electrode 207. To prevent local bending of the master electrode 207 according to the groove pattern, possibly caused by the lower pressure in the vacuum channels, the width of the vacuum grooves are preferably made small, e.g. less than 1 mm in diameter. For the same reason the vacuum channels may have a width that is kept small, such as less than 1 mm. The mouths of the vacuum channels may be evenly distributed on the side of the lower chuck 200 facing the master electrode 207, such that an even vacuum force is obtained on the backside of the master electrode 207. In this way detainment of the master electrode 207 to the lower chuck 200 and conformation between the master electrode 207 and the lower chuck 200 may be increased while simultaneously keeping demands on the vacuum creating unit low.

When loading the master electrode 207 the adjustable seal 204 is extended to a position located above the top surface of the center of the convex interaction surface 201, such that the master electrode 207 rests on the seal 204 after loading. After loading the master electrode 207 on the convex chuck 200, vacuum is applied in the vacuum channels 205 to securely fixate the master electrode 207. In connection to this or at the same time the height of the seal 204 is adjusted to allow it to not extend above and beyond the surface of the interaction surface 201 adjacent to the seal 204. Hence, the master electrode 207 conforms to the convex interaction surface 201, without creating a raised circle around the circumference that can lead to entrapment of electrolyte.

The process chamber is then filled up with electrolyte; as an alternative a thin film of electrolyte may be dispensed only onto the patterned surface of the master electrode 207. The substrate 211 may have been loaded on the top chuck 210 before filling up the chamber or dispensing the electrolyte onto the patterned surface of the master electrode 207. Because of the convex profile of the master electrode 207, the contact will be formed first in the center when the substrate 211 and the master electrode 207 are brought into contact. At this position the vacuum that holds the master electrode 207 is removed and at the same time an over pressure of air, N2 or any other suitable fluid is applied only at the center of the chuck 200, resulting in a flow of pressurized fluid from the center towards the circumference in a small slit that is created from the applied pressure between the backside of the master electrode 207 and the interaction surface 201. Just after applying the pressure, the adjustable seal 204 may be inflated or by other means raised to prevent pressurized fluid from flowing out into the process chamber.

When fluid is flowing from the center towards the circumference there will be a continuous pressure drop, resulting in a pressure gradient with the highest pressure in the center and the lowest pressure at the circumference where the pressurized fluid may escape into the chamber and out of the equipment. The pressure of the fluid may be accurately controlled and the gradient may be adjusted by altering the thickness of the slit between the backside of the master electrode 207 and the interaction surface 201. The pressurized fluid may preferably be applied during the entire process cycle, giving rise to a continuous transport of small volumes of excessive electrolyte from the centre of the master electrode 207 towards the circumference and keeping the excess electrolyte away from the master electrode and substrate interface. Outlets 206 may further be arranged just inside the seal 204 to allow escape of pressurized fluid. These outlets 206 may be controlled to allow a desired flow of fluid, thereby controlling the pressure applied to the backside of the master electrode 207.

In an alternative embodiment, a static pressure is applied to the master electrode 207, whereby the pressurized volume between the interaction surface 201 and the master electrode 207 is being enclosed by the adjustable seal 204.

When the desired process operation has been performed the pressure in the center is removed and replaced with vacuum all over the vacuum groves again to fixate the master electrode 207 on the chuck 200 again. If the chucks 200, 210 have been somewhat separated when adjusting the slit and the resulting pressure gradient, this may preferably be done by first going into hard contact again and then applying the vacuum at the same time as the adjustable seal 204 is lowered to allow it to be at the same level as the adjacent portion of the interaction surface 201. This procedure prevents from non-controlled separation and release of the master electrode 207 from the substrate 211.

If the convex profile of the master is made small enough, the bending of the master electrode 207 according to the profile of the chuck will not have any negative effects on the integrity of the master electrode 207. After fixating the master electrode 207 on the chuck 200 again, a separation force may be applied to move the chuck 200 away from the chuck 210 holding the substrate 211 in a controlled way, preferably keeping the two surfaces of the master electrode 207 and the substrate 211 completely in parallel during the entire separation process.

As an alternative an external separation stage can be used in order to be able to keep the two surfaces in better parallelism during separation.

After separation cleaning with different chemicals may be performed before unloading the substrate 211 or master electrode 207from the equipment and initiating next ECPR cycle.

A yet further example is shown in Fig. 4. In this example, the ECPR equipment includes a process chamber with two planar polished chucks 300, 310 onto which the master electrode 307 and the substrate 311, respectively, are attached to. The lower chuck 300 and the upper chuck 310 are facing each other and they both have small vacuum channels 305, 315 to provide a reliable fixation of the master electrode 307 and the substrate 311. Such vacuum channels 305 are preferably arranged similarly as to what has previously been described.

After loading the master electrode 307 on the lower chuck 300, vacuum is applied by means of the vacuum channels 305 to fixate the master electrode 307. The process chamber is then filled up with electrolyte, or alternatively a thin film of electrolyte is dispensed only onto the surface of the master electrode 307. The substrate 311 may have be loaded on the top chuck 310 before filling the process chamber or dispensing electrolyte onto the surface of the master electrode 307. Subsequently, after loading the substrate 311 on the upper chuck 310 the chucks 300, 310 are brought into contact while keeping substrate 311 and the master electrode 307 in parallel.

When brought into contact the vacuum that holds the master electrode 307 is removed and at the same time an over pressure of air or N2 or any other suitable fluid is applied on one side of the periphery of the master electrode 307, such that the applied over pressure that pushes the master electrode 307 and the substrate 311 towards each other forms a gradient from one side of the master electrode 307 to the other. Hence, the front side of the master electrode 307 is brought into contact with the front side of the substrate 311 by continuously increasing the contact area between the front sides in an analog way towards the borders thereof. This may be accomplished in either of two ways, namely:
1) by applying an over pressure having a continuously extended and at the same time decreasing distribution, starting from one side of the master electrode 307 and spreading symmetrically along the back side of the master electrode 307, or
2) by implementing a tilt stage onto which the lower chuck 300 is mounted on, whereby the tilting angle is continuously decreased when the master electrode 307 is brought into contact with the substrate 311.

In case of the first alternative, the pressure may be applied by using one of the outlets 306 as an inlet for pressurized fluid. Hence, the pressurized fluid will flow upwards into the slit formed between the upper surface of the chuck 300 and the back side of the master electrode 307. Thus, a pressure gradient will be present, having a maximum at a local periphery of the master electrode 307.

Once the master electrode 307 is in contact with the substrate 311, the angle a between them can be diminished without loosing the contact between them, until they are parallel to each other and hence in contact from one side to the other.

The applied pressure is propagating in a small slit between the backside of the master electrode 107 and the upper surface of the chuck 100. The small slit is formed by the applied pressure, pressing the master electrode 107 in an up-wise direction towards the substrate 111. Alternatively, the substrate 111 is pressed in an down- wise direction towards the master electrode 107 by means of an external pressure source (not shown).

The pressure may be accurately controlled and the gradient can thus be adjusted by altering the thickness of the slit between the backside of the master electrode 107 and the chuck surface.

The pressurized fluid may preferably be applied during the entire process cycle, giving rise to a continuous transport of small volumes of excessive electrolyte towards the circumference. In a particular example, as shown in Fig. 4, an optional seal 304 is included in the lower chuck 300. The seal 304 is located just inside the circumference of the master electrode 307, to prevent pressurized media from flowing out in the process chamber. Further, the seal 304 is inflatable or by other means adjustable in a direction perpendicular to the patterned surface of the master electrode 307.

When the master electrode 307 is brought into contact with the substrate 311 the seal 304 is deflated or by other means adjusted such that it is positioned underneath the top surface of the chuck 300. Hence, the formation of a raised circle around the circumference that can lead to entrapment of electrolyte is prevented.

In a yet further example, outlets 306 are provided in the lower chuck 300 to allow escape of pressurized fluid. The pressure of these outlets 306 may be controlled to allow the desired escape of fluid, thereby enabling controlling the pressure.

When the ECPR process is finished the over pressure applied to the center is removed and replaced with vacuum to the vacuum grooves 305 in order to fixate the master electrode 307 on the chuck 300 again. After fixating the master electrode 307 on the chuck 300 again, a separation force may be applied to move the chuck 300 away from the chuck 310 holding the substrate 311 in a controlled way, preferably keeping the two surfaces of the master electrode 307 and the substrate 311 completely in parallel during the entire separation process.

As an alternative an external separation stage can be used in order to be able to keep the two surfaces in parallel during separation.

After separation cleaning with different chemicals may be performed before unloading the substrate 311 or master electrode 307 from the equipment and initiating next ECPR cycle.

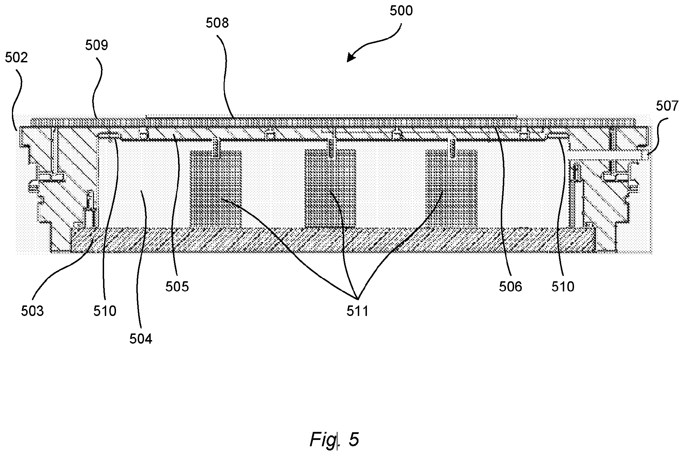

In Fig. 5 another example of a dome shaped/convex chuck is disclosed. Also this lower chuck 500 is adapted to minimize the thickness and variations in residual film of electrolyte, without local and/or global entrapment of electrolyte. This is ensured by bringing the master electrode and the substrate together in a manner such that the surface of a front side of the master electrode, carrying the patterned insulating layer forming a pattern of conductive cavities there between, and the surface of a front side of the substrate, being the side of the substrate intended for pattern replication or etching, into contact by continuously increasing the contact area between the front sides towards the borders thereof, in accordance with above. This may be accomplished by adapting the lower chuck 500 such that the master electrode, and thereby the front side of the master electrode is slightly bent into a convex form according to above, by instead providing an overpressure within the lower chuck 500. More specifically, the lower chuck 500 comprises a distal/upper chuck piece 502 and a proximal/lower chuck piece 503. The distal/upper chuck piece 502 and the proximal/lower chuck piece 503 may be manufactured in steel, such as stainless steel. The distal/upper chuck piece 502 is mounted on the proximal/lower chuck piece 503, such that a void 504 is obtained distally of the proximal/lower chuck piece 503 and proximally of the distal/upper chuck piece 502. Thus, a membrane 505 is obtained distally of the void 504.

Under the circumstances, this membrane 505 is preferably a planar sheet. An interaction surface 506 is created on the distal side of the membrane 505. The membrane 505 may extend laterally of the interaction surface 506, and thus the lateral borders of the membrane 505 circumvent the interaction surface 506. When the area of the membrane 505 is greater than the area of the interaction surface 506 in the horizontal plane, the flexure of the membrane 505 will optimize the suitability of its curvature for avoiding enclosure of electrolyte at the borders of the master electrode or the substrate.

The thickness of the membrane 505, in the proximodistal extension, may be selected to be in the interval of 2,5 to 15 mm. When the thickness is in this interval, over pressures of not to extreme values may be used in the void 504, while still maintaining a good control of the convex shape. Suitable pressures adapted to obtain suitable convexity of the interaction surface 506, when using the above identified thicknesses for the membrane 505, may be selected in the interval of 1 to 6 atm, i.e. from atmospheric pressure, when for example the master electrode and the substrate are parallel, to 5 bar over pressure when using thicker membranes 505, to obtain the suitable convex shape of the interaction surface 506. When the thickness is in the interval of 5 to 10 mm, this is especially true, while also providing for facilitated manufacturing methods. The use of membranes in this thickness span allows for control of convex shape, created by an over pressure in the void 504, while withstanding opposing forces from the electrolyte on the printing side of the master electrode. Specifically, the membrane 505 may be pushed distally/upwards by the pressure in the void to a difference in height of up to for example 300 micrometers, such as 150 micrometers, between atmospheric pressure and the applied over pressure, on the global scale.

The void 504 communicates via a pressure channel 507 to a suitable pressurizing unit (not shown). The distal/upper chuck piece 502 may be mounted on the lower/proximal chuck piece 503 with screw members. These screw members may be arranged circumferentially of the void 504. The void 504 is positioned proximally of the interaction surface 506 and substantially corresponds in transversal extension to the transversal extension of said interaction surface 506, such that an over pressure in said void 504 brings said interaction surface 506 into a convex shape, such that said master electrode or said substrate arches distally in said resting position.

When a pressure is applied in the void 504, the distal/upper chuck piece 502 will pressed upwards/distally, and thus start to form a dome shaped or convex distal or upper surface. The cross-section of the distal or upper surface along the transversal plane may then be substantially segmental arch shaped, according to above. The dome shaped or convex distal or upper surface 506 is intended for interaction with the master electrode in use. During use, an electrically conductive sheet/foil 508 is applied onto the distal or upper surface 506, before the pressure is applied in the void 504, through which the master electrode is provided with voltage and current. Then, the master electrode is applied onto and clamped to the lower chuck 500. In between the distal/upper surface 506 and the conductive foil 508 a cushion sheet 509 may be applied. The cushion sheet 509 may for example be made in a material selected from the group of rubber and plastic foams. When the cushion sheet 509 is applied between the distal/upper surface 506 and the conductive foil 508, compensation on a macro and micro scale between the chuck 500 and the master electrode or substrate mounted thereon may be improved, such the risk of local entrapments of electrolyte and/or gas in the electrolyte in between the master electrode and the substrate may be minimized. Even though the membrane 505 changes several hundreds of micrometers in height along the proximodistal axis, it is still rigid on the local scale. The cushion sheet 509 may then absorb irregularities on the local scale. The function of the cushion sheet 506 and the conductive foil 508 is to add the compliant nature to the chuck construction. That means that the master sits on top of the combination of the cushion sheet 506 and the conductive foil 508 to control the shape on the global scale to squeeze out the electrolyte from the centre to the edge, as well as giving the compliant nature that is forgiving in terms of particles getting trapped between the wafers or local topography that is existing on for example customer wafers.

Thereafter, the pressure is applied in void 504, to press the distal/upper chuck piece 502 such that the distal interaction surface, the electrically conductive foil, and the master electrode forms a the same dome shaped or convex shape. Alternatively, the pressure is applied before the conductive foil and/or the master electrode are applied to the interaction surface, to thereafter, i.e. by applying vacuum in between the interaction surface and the conductive foil and/or the master electrode shape the conductive foil and the master electrode in to the same shape as the interaction surface, i.e. a dome or convex shape.

Thereafter, the master electrode and the substrate are brought together with an electrolyte in between the two. The master electrode and the substrate may be brought together with a high enough pressure to overcome the over pressure in the void 504 and press the interaction surface proximally into a substantially planar shape. Alternatively, the pressure in the void 504 is lowered while bringing the master electrode and the substrate together, such that the same substantially planar shape of the interaction surface, the master electrode, and the substrate is obtained.

The proximal side of the distal/upper chuck piece 502 may be provided with trench 510. The trench 510 is positioned in the void 504. The trench 510 provides a decrease in thickness of the membrane 505. The trench 510 is positioned on the proximal side of the membrane 505. The position of the trench 510 corresponds to a position on the distal side of the membrane 505 being located laterally of the interaction surface 506, i.e. on a distance from the central axis of the chuck piece radially outwards from the interaction surface 506. When the pressure is applied in the void 504, the trench 510 will act as a hinge, making the distal/upper chuck piece 502, i.e. the membrane 505, start to bend into a dome/convex shape in this position. The trench 510 may be ring shaped, circumferentially of the interaction surface 506. Also, the hinge function of the trench 510 improves reproducibility of the lateral error during movement along the proximodistal axis.

Inside the void 504, height sensors 511 may be positioned, to detect the movement of the distal/upper chuck piece 502 in the proximodistal direction. The void may be provided with one or more sensors, for instance four sensors 511. At least one, such as three, of these may be positioned at laterally, just inside the trench 510, while one may positioned centrally. The centrally positioned sensor will then detect the movement of the distal/upper chuck piece 502 in the proximodistal direction, where the movement is greatest, while the other detects movement on positions corresponding to the edges of the master electrode, such as placed with 120 degrees interval. These sensors may communicate with the pressure unit, or other forms of control units, to assure that the pressure or the movement of the upper and lower chucks are adapted to shape the interaction surface into a suitable dome/convex shape, and that a planar shape is obtained when the master electrode and the substrate are brought together. Thus, when the lower chuck comprises a void 504, the sensors 511 may be positioned in said void, instead of a more complicated position (and then also another kind of sensor). The different sensors, i.e. the centre sensor and the sensors closer to the edge, may be used alternately, to define if the master electrode and the substrate are in contact, loose contact etc, depending on the relative detection among the different sensors.

The interaction surface 506 is provided with an electrically conductive member, such as a conductive foil, in accordance with above. The conductive member is in conductive communication with an external power supply, whereby the conductive member may be current-carrying. The conductive member is arranged on the interaction surface such that the conductive member conductively connects to conductive parts on the master electrode to be arranged on the distal/upper chuck piece 502, said conductive parts of the master electrode being in conductive communication with the conductive surface in cavities of the master electrode. The electrical leads may then be spread over the interaction surface, whereby electrical contact with the master electrode may be more homogenous than a limited electrical contact at the periphery of the master electrode. Thus, a better controlled ECPR process may be obtained.

A substrate and a master electrode may be attached to an upper chuck and a lower chuck according to the example of Fig 5 in accordance with above. Hence, a first contact is established between the centre of the master electrode and the centre of the substrate.

During this process, all excessive electrolyte will be forced to move away from the centre towards the periphery of the master electrode/substrate sandwich. Hence, mechanical contact will be established between the patterned surface of the master electrode and the substrate.

Also, typically a lot of wafers have something called a wedge-error. It means that on one side of the wafer compared to the other it can be somewhat thicker. Typically, wedge- areas of a substrate, such as a silicon wafer, are between 5 and 20 micrometers thicker than another area on the wafer. The chucks and methods of the present inventions may compensate for this extra thickness in such wedge area on each individual wafer, with a built in a self-compensating mechanism.

It is readily understood that all references to lower/upper are merely for illustrative purposes. Moreover, it should be realized that equivalent setups to those described may include setups having a substrate arranged on a lower chuck while the master electrode is mounted on an upper chuck, as well as setups in which the positions of the lower and upper chuck are switched.

In the claims, the term "comprises/comprising" does not exclude the presence of other elements or steps. Furthermore, although individually listed, a plurality of means, elements or method steps may be implemented by e.g. a single unit or processor.

The terms "a", "an", "first", "second" etc do not preclude a plurality.

## Claims

1. A chuck (200) for holding a master electrode (207) or a substrate (211) during an ECPR process, said chuck comprising
a distal interaction surface (201) for arrangement of the master electrode (207) or the substrate (211) thereon, and
attaching means (205) for clamping said master electrode (207) or said substrate (211) to said interaction surface (201), such that said master electrode (207) or said substrate (211) is substantially conforming to the shape of said interaction surface (201) in a resting position of the interaction surface (201) and the master electrode (207) or the substrate (211) arranged thereon,
wherein said interaction surface (201) has a convex shape, such that said master electrode (207) or said substrate (211) arches distally in said resting position and **characterized in that** the chuck further comprises a seal (204) arranged at the periphery of said interaction surface (201), wherein the dimensions of said seal (204) are adjustable in a direction perpendicular to the surface of the master electrode (207) or the substrate (211).

2. The chuck according to claim 1, wherein the interaction surface is flexible in the distal/proximal direction, such that the interaction surface (201), and the master electrode (207) or the substrate (211) arranged thereon, may be transferred from said resting position into an active position when a pressure is applied in a proximal direction, wherein the master electrode (207) or the substrate (211) is planar in said active state.

3. The chuck according to claim 1 or 2, wherein said convex shape of said interaction surface (201) has a diameter that substantially corresponds to the diameter of said master electrode (207) or substrate (211).

4. The chuck according to any of claims 1 to 3, wherein said chuck comprises an intermediate surface of a first material, proximally of the distal interaction surface, and said interaction surface (201) is made of a second material, said second material being more elastic than said first material.

5. The chuck according to any of claims 1 to 4, wherein the convex shape of the interaction surface (201) is in the range of 0, 1 to 100 µπ 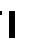 in height difference from center to circumference.

6. The chuck according to any of claims 1 to 5, wherein said attachment means (205) comprises a vacuum source.

## Patentansprüche

1. Haltevorrichtung (200) zum Festhalten einer Masterelektrode (207) oder eines Substrats (211) während eines ECPR-Verfahrens, wobei die Haltevorrichtung umfasst:
eine distale Interaktionsfläche (201) zur Anordnung der Masterelektrode (207) oder des Substrats (211) darauf, und
ein Befestigungsmittel (205) zum Aufspannen der Masterelektrode (207) oder des Substrats (211) auf der Interaktionsfläche (201), sodass die Masterelektrode (207) oder das Substrat (211) im Wesentlichen konform zu der Form der Interaktionsfläche (201) in einer Ruheposition der Interaktionsfläche (201) und der darauf angeordneten Masterelektrode (207) oder des darauf angeordneten Substrats (211) ist,
wobei die Interaktionsfläche (201) eine konvexe Form hat, sodass die Masterelektrode (207) oder das Substrat (211) sich in der Ruheposition distal wölbt, und
**dadurch gekennzeichnet, dass** die Haltevorrichtung weiter ein am Randbereich der Interaktionsfläche (201) angeordnete Dichtung (204) umfasst, wobei die Abmessungen der Dichtung (204) in einer Richtung senkrecht zur Oberfläche der Masterelektrode (207) oder des Substrats (211) einstellbar sind.

2. Haltevorrichtung nach Anspruch 1, wobei die Interaktionsfläche in der distalen/proximalen Richtung flexibel ist, sodass die Interaktionsfläche (201), und die darauf angeordnete Masterelektrode (207) oder das darauf angeordnete Substrat (211), von der Ruheposition in eine aktive Position überführt werden können, wenn ein Druck in einer proximalen Richtung ausgeübt wird, wobei die Masterelektrode (207) oder das Substrat (211) in dem aktiven Zustand planar ist.

3. Haltevorrichtung nach Anspruch 1 oder 2, wobei die konvexe Form der Interaktionsfläche (201) einen Durchmesser aufweiset, der im Wesentlichen dem Durchmesser der Masterelektrode (207) oder des Substrats (211) entspricht.

4. Haltevorrichtung nach einem der Ansprüche 1 bis 3, wobei die Haltevorrichtung eine Zwischenfläche aus einem ersten Material, proximal von der distalen Interaktionsfläche, umfasst und die Interaktionsfläche (201) aus einem zweiten Material besteht, wobei das zweite Material elastischer als das erste Material ist.

5. Haltevorrichtung nach einem der Ansprüche 1 bis 4, wobei die konvexe Form der Interaktionsfläche (201) im Bereich von 0,1 bis 100 µm Höhenunterschied von der Mitte bis zum Umfang liegt.

6. Haltevorrichtung nach einem der Ansprüche 1 bis 5, wobei das Befestigungsmittel (205) eine Vakuumquelle umfasst.

## Revendications

1. Support (200) pour soutenir une électrode maître (207) ou un substrat (211) au cours d'un procédé ECPR, ledit support comprenant :
une surface distale d'interaction (201) pour que vienne s'y disposer l'électrode maître (207) ou le substrat (211) ; et
un moyen de fixation (205) pour serrer ladite électrode maître (207) ou ledit substrat (211) contre ladite surface d'interaction (201), d'une manière telle que ladite électrode maître (207) ou ledit substrat (211) épouse essentiellement la configuration de ladite surface d'interaction (201) dans une position de repos de la surface d'interaction (201) et de l'électrode maître (207) ou du substrat (211) disposé par-dessus ;
dans lequel ladite surface d'interaction (201) possède une configuration de forme convexe, d'une manière telle que ladite électrode maître (207) ou ledit substrat (211) présente une configuration arquée en direction distale dans ladite position de repos, et **caractérisé en ce que** le support comprend en outre un joint d'étanchéité (204) disposé à la périphérie de ladite surface d'interaction (201), dans lequel les dimensions dudit joint d'étanchéité (204) peuvent être réglées dans une direction perpendiculaire à la surface de l'électrode maître (207) ou du substrat (211).

2. Support selon la revendication 1, dans lequel la surface d'interaction est flexible dans la direction distale/proximale, d'une manière telle que la surface d'interaction (201) et l'électrode maître (207) ou le substrat (211) disposé par-dessus peuvent être transférés à partir de ladite position de repos jusque dans une position active lorsqu'on exerce une pression dans une direction proximale, l'électrode maître (207) ou le substrat (211) étant de forme plane dans ledit état actif.

3. Support selon la revendication 1 ou 2, dans lequel ladite configuration de forme convexe de ladite surface d'interaction (201) possède un diamètre qui correspond essentiellement au diamètre de l'électrode maître (207) ou du substrat (211).

4. Support selon l'une quelconque des revendications 1 à 3, dans lequel ledit support comprend une surface intermédiaire constituée d'une première matière, en position proximale de la surface distale d'interaction, et ladite surface d'interaction (201) est constituée d'une seconde matière, ladite seconde matière étant plus élastique que ladite première matière.

5. Support selon l'une quelconque des revendications 1 à 4, dans lequel la configuration de forme convexe de la surface d'interaction (201) présente une différence en hauteur dans la plage de 0,1 à 100 µm depuis le centre jusqu'à la circonférence.

6. Support selon l'une quelconque des revendications 1 à 5, dans lequel ledit moyen de fixation (205) comprend une source de vide.
